# EUROPEAN PATENT APPLICATION

(11) **EP 4 312 239 A1**
(43) Date of publication of application: **31.01.2024**
(21) Application number: 23186653.4
(22) Date of filing: 20.07.2023
(51) Int. Cl.: H01F 27/28, H01F 41/04, H01F 17/00

(54) **METHOD OF MANUFACTURING SEMICONDUCTOR DEVICES AND CORRESPONDING SEMICONDUCTOR DEVICE**

(30) Priority: 28.07.2022 IT 202200016011
(71) Applicant: STMicroelectronics S.r.l., 20864 Agrate Brianza (MB) (IT)
(72) Inventor: HALICKI, Damian, I-20864 Agrate Brianza (Monza Brianza) (IT); DERAI, Michele, I-20149 Milano (IT)
(74) Representative: Bosotti, Luciano

(57) **Abstract**

Semiconductor devices of the type currently referred to as a System in a Package or SiP and having embedded therein a transformer are produced by embedding at least one semiconductor chip (14) in an insulating encapsulation (180) at a first portion thereof.

Over a second portion of the substrate at least partly non-overlapping with the first portion of the substrate (180) having the at least one semiconductor chip (14) embedded therein, stacked structure is formed including a plurality of layers of electrically insulating material (Ll, L2, L3, L4) as well as respective patterns of electrically conductive material. The respective patterns of electrically conductive material have:
a planar coil geometry, thus providing electrically conductive coils such as the windings of a transformer (181, 182) or
a geometrical distribution providing electrically conductive connections to one or more semiconductor chips (14).

## Description

### Technical field

The description relates to manufacturing semiconductor devices comprising electrical coils, for instance in a transformer.

Solutions as described herein can be applied, for instance, to DC/DC converters, galvanic insulators and, generally, to semiconductor device packages having coils embedded therein.

### Background

Semiconductor devices of the type currently referred to as a System in a Package or SiP may have embedded therein (high performance) transformers.

These transformers can be formed starting from a core laminate. This approach may be fairly expensive; additionally, the presence of leadframe portions onto which the transformer rests leads to coupling with the metal (e.g., copper) of the leadframe with associated losses. These losses are primarily due to the metallic frame acting as a shield thus adversely affecting mutual coupling of the coils.

A transformer integrated with a so-called Fan Out Panel Level Package (FOPLP) formed over silicon is described, for instance, in Z. Wang, et al: "A transformer using two RDL metal layers based on Fan-Out Panel Level Package Technology", 2021 J Phys: Conf.Ser. 1971 012041. Such an approach also causes coupling with silicon and ensuing losses. It is noted that the transformer has a size comparable with the size of the die, which makes it unsuitable for power applications.

Document US 2022/028593 A1 discloses an electronic device including a multilevel package substrate, conductive leads, a die, and a package structure. The multilevel package substrate has a first level, a second level, and a third level, each having patterned conductive features and molded dielectric features. The first level includes a first patterned conductive feature with multiple turns that form a first winding. The second level includes a second patterned conductive feature, and the third level includes a third patterned conductive feature with multiple turns that form a second winding. A first terminal of the die is coupled to the first end of the first winding, a second terminal of the die is coupled to the second end of the first winding, and a third terminal of the die is coupled to a first conductive lead. The package structure encloses the first die, the second die, and a portion of the multilevel package substrate.

### Object and summary

Solutions as described herein aim at contributing in addressing adequately the issues discussed in the foregoing.

According to solutions as described herein, such an object can be achieved by means of a method having the features set forth in the claims that follow.

One of more embodiments may also relate to a corresponding semiconductor device having a coil (e.g., a transformer) embedded therein.

One or more embodiments provide a circuit layout wherein a coil is integrated in a System in a Package (SiP) using Panel Embedded Package, PEP technology.

In various embodiments, coils can be formed in metallization levels of PEP technology giving rise to a System in Package layout wherein the die/dice and the coil/coils are (at least substantially) not overlapping with each other.

Advantages of solutions as described herein can be summarized as follows:
one or more coils, e.g., for a transformer can be created using a metal (e.g., copper) plating thus avoiding mounting a coil in a package;
electrical performance is improved with inductance increased thanks to the absence of a metal pad for the coil or coils; resistance is also reduced due to wires being replaced via, e.g., DCI interconnections with advantages also in terms of coupling coefficient and Q-factor;
the overall package thickness can be reduced with possible reduction of package footprint; and
flexibility in package layout is increased with a possible cost reduction.

Solutions as described herein take advantage of LDS/DCI technology and contemplate forming the coil/transformer directly in the package molding.

In that way, providing a support frame, a transformer substrate and related processes (wire bonding/die/substrate attach) can be avoided.

Solutions as described herein may also facilitate reducing package dimensions (both in terms of footprint and of thickness) while improving electrical performance.

### Brief description of the several views of the drawings

One or more embodiments will now be described, by way of example only, with reference to the enclosed figures, wherein:
Figure 1 is a perspective view of a conventional system in a package, SiP having a transformer embedded therein,
Figure 2 is a lateral view of a conventional system in a package, SiP taken along line II-II of Figure 1,
Figure 3 is a perspective view of a system in a package, SiP according to embodiments of the present description,
Figure 4 is a plan view of the system in a package, SiP of Figure 3,
Figure 5 is a lateral view of a system in a package, SiP according to embodiments of the present description taken along line V-V of Figure 4,
Figure 6 is a perspective view of another system in a package, SiP according to embodiments of the present description,
Figure 7 is a plan view of the system in a package, SiP of Figure 6,
Figure 8 is a lateral view of a system in a package, SiP according to embodiments of the present description taken along line VIII-VIII of Figure 7, and
Figures 9A to 9N are illustrative of a sequence of steps according to embodiments of the present description.

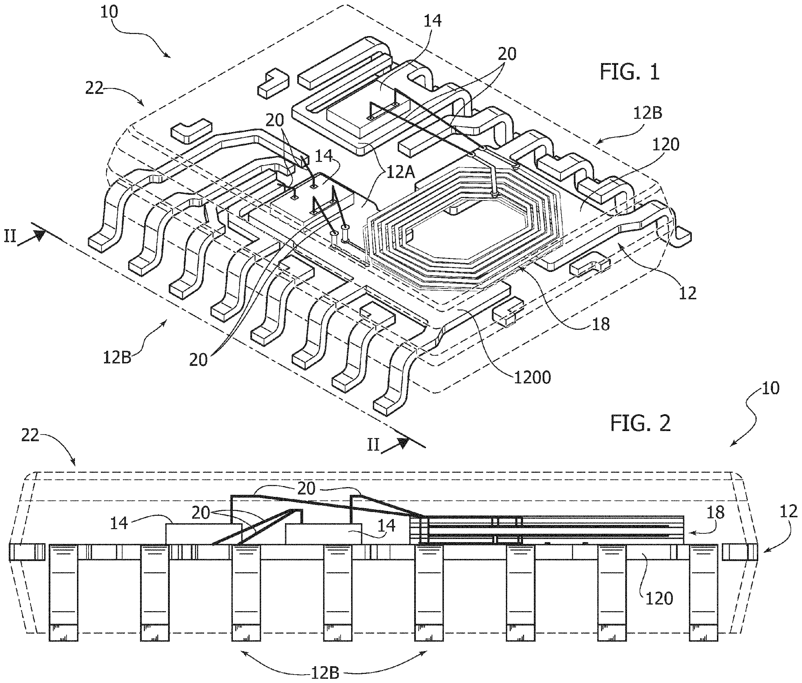

It is noted that in Figures 1 to 8, various elements are represented as "transparent" in order not to obscure the presence of other elements in the figures. This applies e.g., to the lateral views of Figures 2, 5 and 8.

The figures are drawn to clearly illustrate the relevant aspects of the embodiments and are not necessarily drawn to scale.

Corresponding numerals and symbols in the different figures generally refer to corresponding parts unless otherwise indicated: consequently, like parts or elements are indicated in the various figures with like reference signs, and a corresponding description will not be repeated for each and every figure. The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description manufacturing a single device will be described, being otherwise understood that current manufacturing processes of semiconductor devices involve manufacturing concurrently plural devices that are separated into single individual devices in a final singulation.

Figures 1 and 2 are exemplary of a conventional System in a Package or SiP 10 comprising a substrate (leadframe) 12 including die-mounting areas (die pads) 12A plus an array of electrically conductive leads 12B distributed sideways of the die pads 12A. One or more semiconductor dice or chips 14 are mounted at the die pads 12A.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the chip or die to other electrical components or contacts.

Essentially, a leadframe comprises an array of electrically-conductive formations (or leads, e.g., 12B) that from an outline location extend inwardly in the direction of a semiconductor chip or die (e.g., 14) thus forming an array of electrically-conductive formations from die pads (e.g., 12A) configured to have - at least one - semiconductor chip or die attached thereon.

The package 10 also includes, resting on support portions 1200 formed in the leadframe 12, a transformer 18.

The transformer 18 may comprise primary and secondary windings (coils) connected to the dice or chips 14 via wiring 20.

An encapsulation 22 of insulating material (an epoxy resin, for instance) is molded onto the assembly thus formed leaving the leads 12B protruding from the encapsulation 22 (which is shown in transparency in order not to obscure the other elements of the package 10).

The encapsulation 22 surrounds the circuit material to protect it from corrosion or physical damage while facilitating mounting of the electrical contacts, connecting the package to a mounting substrate (a Printed Circuit Board, PCB, for instance - not visible in the figures).

During operation, the coils in the transformer 18 create a magnetic field that inevitably interacts with the metal (e.g., copper) material of the leadframe 12 (at the portions designated 1200) which undesirably affects electrical performance.

The wiring patterns 20 may also create constraints in terms of electrical performance and package footprint dimensions. It is observed that standard wire interconnections result in (very) poor layout flexibility in the case of packages having embedded coils such as the transformer 18.

Embedding such coils in a standard leadframe-based package also results in a fairly complex assembly process. Conventional solutions to implement a transformer in a package may in fact involve integrating a transformer built over a dielectric substrate (e.g., of the type using ball grid array/land grid array (BGA/LGA) arrangements) connected through conventional wire bonding to silicon dice. A leadframe having a customized design may be required in order to facilitate complying with galvanic isolation constraints and reducing the presence of metal parts.

To summarize:
the substrate of the transformer (this may be a 6-layer substrate having a thickness of, e.g., 0.4 mm) rests on one or more metal pads 1200 in the leadframe, which leads to a reduction of electrical performance;
standard interconnections using wires such as 20 also adversely affect electrical performance insofar as they may introduce undesired electrical resistance;
a coil, such as a transformer coil 18 housed on a substrate as exemplified in Figures 1 and 2, may have a high cost;
a "specialized" leadframe 12 may be required to accommodate the coil or coils;
the substrate housing the coil takes a certain space in the package 10, resulting in a footprint increase; and
additional and fairly complex assembly steps may be involved.

Laser direct structuring, LDS is a laser-based machining technique now widely used in various sectors of the industrial and consumer electronics markets, for instance for high-performance antenna integration, where an antenna design can be directly formed onto a molded plastic part. In an exemplary process, the molded parts can be produced with commercially available insulating resins that include additives suitable for the LDS process; a broad range of resins such as polymer resins like PC, PC/ABS, ABS, LCP are currently available for that purpose. A laser beam can be used to transfer ("structure") a desired electrically conductive pattern onto a plastic molding that may then be subjected to metallization to finalize a desired conductive pattern. Metallization may involve electroless plating followed by electrolytic plating. Electroless plating, also known as chemical plating, is a class of industrial chemical processes that creates metal coatings on various materials by autocatalytic chemical reduction of metal cations in a liquid bath. In electrolytic plating, an electric field between an anode and a workpiece, acting as a cathode, forces positively charged metal ions to move to the cathode where they give up their charge and deposit themselves as metal on the surface of the workpiece.

LDS is oftentimes referred to also as direct copper interconnection, DCI. This is primarily with reference to a package family wherein conventional wire bonding is replaced with copper plated vias and lines (traces). Laser Induced Strip Interconnection, LISI and Panel Embedded Package, PEP are designations of possible subfamilies of DCI packages.

Documents such as US 2018/342453 A1, US2019/115287 A1, US 2020/203264 A1, US 2020/321274 A1, US 2021/050226 A1, US 2021/050299 A1, US 2021/183748 A1, or US 2021/305203 A1 (all assigned to the same assignee of the present application) are exemplary of the possibility of applying LDS technology in manufacturing semiconductor devices.

Solutions as described herein may take advantage of LDS/DCI technology as a solution to provide device interconnections with a substrate via metal (such as copper) grown (directly) with additive processes.

A Ti/Cu sputtering process can be used to create a seed layer for both coils and interconnections. This may be followed by metallization (growing metal such as copper via a plating process, for instance) to grow a thicker conductive structure.

Providing coils embedded in a package is thus simplified with overall electrical performance improved.

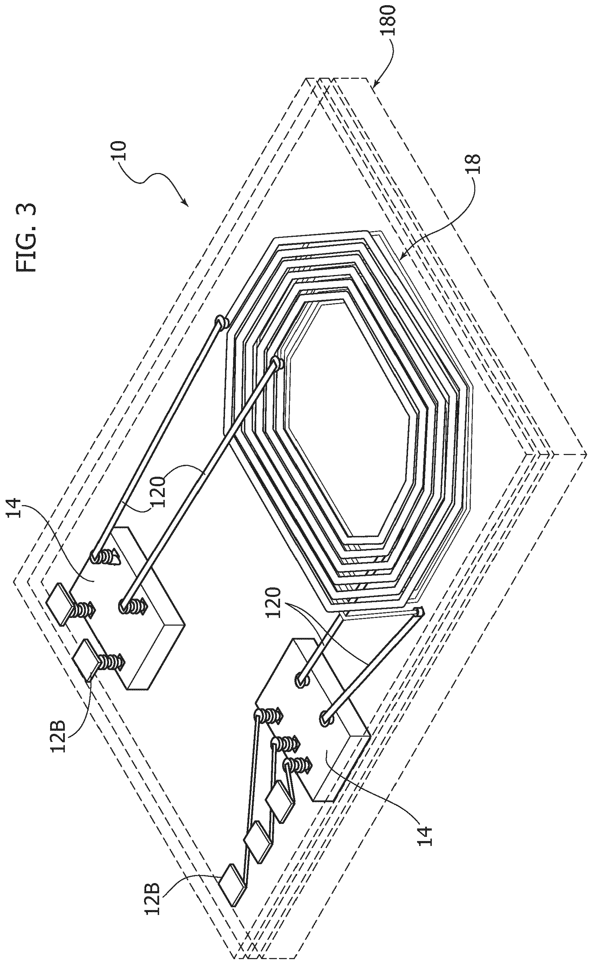

Two possible implementations of solutions as described herein are illustrated in Figures 3 to 5 and Figures 6 to 8, respectively.

For the sake of simplicity and in order to facilitate appreciating the advantages of the solutions described herein, in Figures 3 to 8 parts or elements like parts or elements already discussed in connection with Figures 1 and 2 are indicated (at least in part) with like reference symbols.

It will be otherwise appreciated the fact that certain parts or elements are indicated with like reference symbols in Figures 1 and 2 and in Figures 3 to 8 does not necessarily mean that these parts or elements are implemented in the same manner.

Generally, (also) in Figures 3 to 8, numerals 14 denote semiconductor chips coupled to the coils (primary side and secondary side) of a transformer 18, while the electrically conducting pins or leads providing electrical contacts for the package 10 are indicated as 12B.

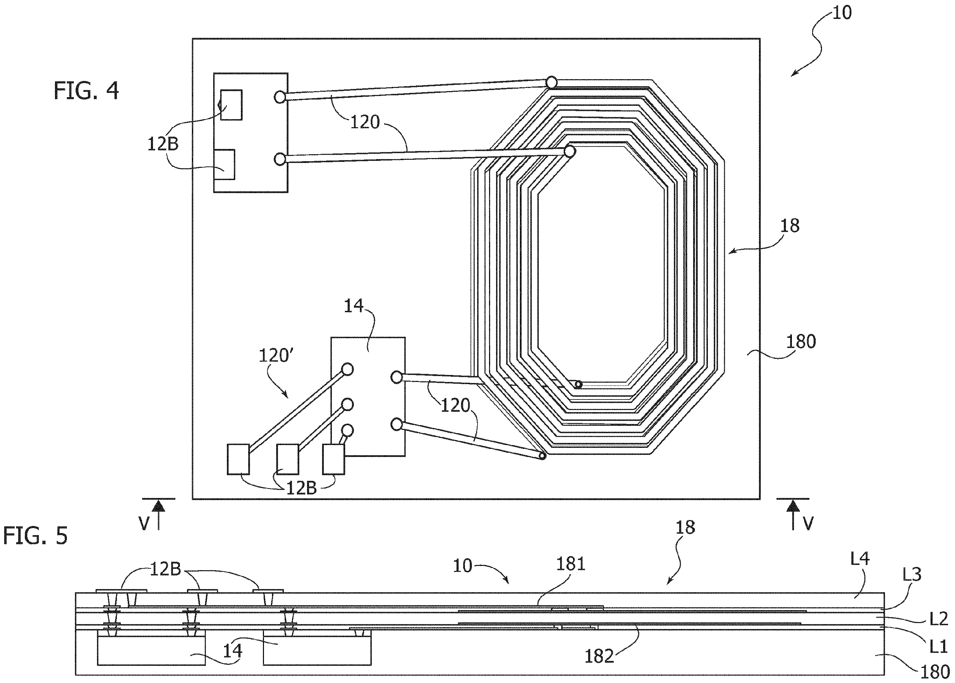

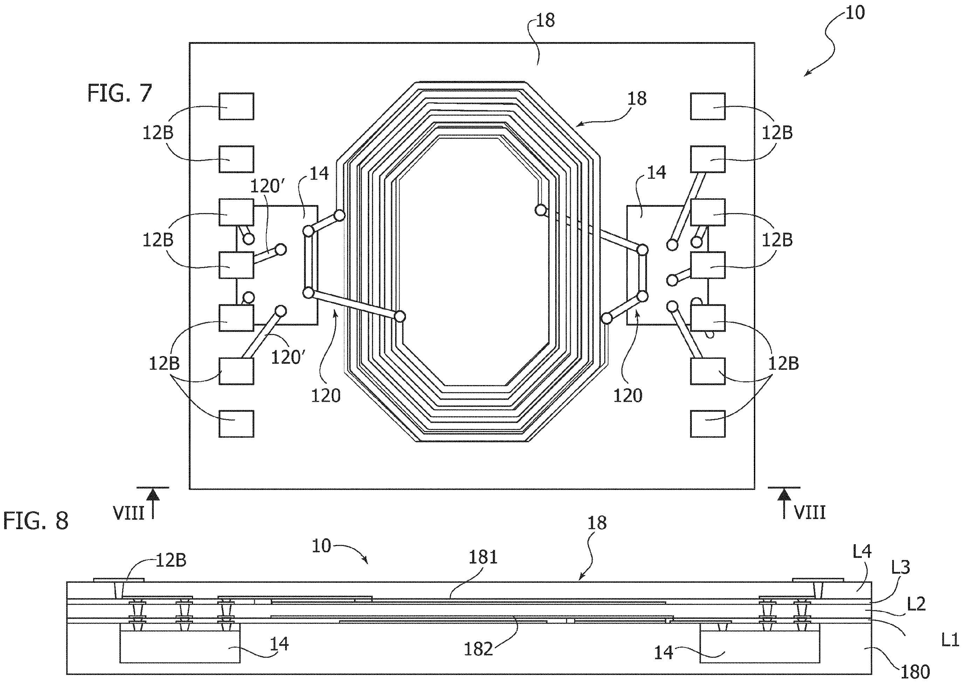

As better appreciable in the lateral views of Figures 5 and 8, in solutions as described herein, both the coils 181, 182 (at the primary and the secondary sides of the transformer 18) can be formed with PEP technology.

This gives rise to a sandwiched structure comprising (from the bottom to the top in Figure 5):
a substrate 180 (e.g., an insulating layer of mold material 180 such as epoxy resin such as the encapsulation 22 of Figures 1 and 2) having a thickness of, e.g., 450 microns having the chips or dice 14 embedded therein (in a manner known per se to those of skill in the art), and
a stacked arrangement of (e.g., four) layers L1, L2, L3, L4 of electrically insulating material having the primary and secondary coils 181, 182 of the transformer 18 and the associated wiring (designated 120) formed therein as respective patterns of electrically conductive material.

Figures such as Figure 5 are thus exemplary of embedding at least one semiconductor chip 14 in an insulating encapsulation 180 at a first portion thereof, and forming over a second portion of the insulating encapsulation 180 at least partly non-overlapping with the first portion of the insulating encapsulation 180 one or more electrically conductive coils 181, 182. These coils have a planar coil geometry and a geometrical distribution of electrically conductive connections 120 to the semiconductor chip 14.

Figures such as Figure 5 are likewise exemplary of forming over the insulating encapsulation 180 having the semiconductor chip 14 embedded in the first portiona stacked structure of layers. The layers in the stacked structure include electrically insulating material L1, L2, L3, L4 as well as respective patterns 1006, 1008, 12B of electrically conductive material.

These patterns of electrically conductive material have:
either a planar coil geometry providing electrically conductive coils 181, 182,
or a geometrical distribution, thus providing electrically conductive connections 120.

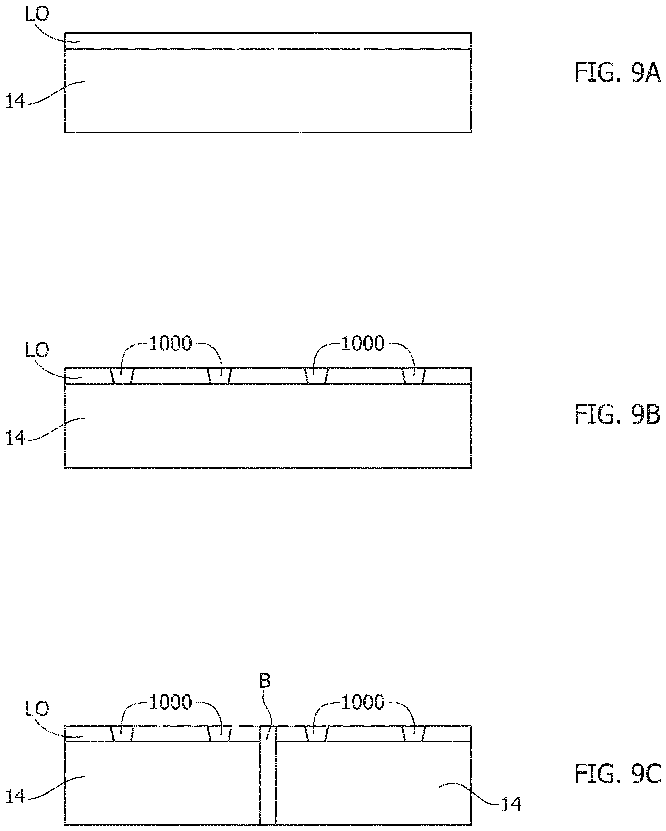

As further discussed in the following, these layers L1 to L4 can be laminated at a "panel" level over an underlying layer (referred to as L0 in Figures 9A to 9N) that can be laminated at "wafer" level.

Advantageously, these layers can comprise sheets/films of an LDS/DCI molding compound suited for processing as discussed in the following

The laminated film can be an Ajinomoto Build-up Film^{®} (ABF), an organic thermosetting film commercialized by the Ajinomoto Group.

Merely by way of example, the layers in question may have the following thicknesses:
L1: 50 microns,
L2: 100 microns,
L3: 50 microns, and
L4: 150 microns.

Of course, the quantitative values reported in the foregoing are merely exemplary and not limiting for the embodiments.

As further detailed in the description of the sequence of steps of Figures 9A to 9N, processing of the substrate 180 and the layers L0, L1, L2, L3, L4 involves forming therein electrically conductive patterns such as vias and electrically conductive lines to provide:
the coils (primary and secondary windings 181, 182) of the transformer 18, and
the wiring 120 as well as through vias that facilitate (see primarily Figures 4 and 7) electrical connection of the dice or chips 14 with the coils or windings of the transformer 18, and - possibly - (see 120' in Figures 4 and 7) electrically conductive lines between the chips or dice 14 and associated leads 12B.

In solutions as described herein one or more semiconductor chips 14 are thus arranged at a first portion of a substrate 180 and one or more electrically conductive coils 181, 182 are formed over a second portion of the substrate 180. The second portion is at least partly non-overlapping with the first portion.

The coil or coils 181, 182 have:
a planar coil geometry, and
a geometrical distribution of electrically conductive connections 120 to the semiconductor chip or chips 14.

Solutions as described herein comprise forming over the second portion of the substrate 180 a stacked structure of layers of electrically insulating material L0, L1, L2, L3, L4 where respective patterns (see, e.g, 1000, 1006, 1008, 12B in Figures 9A to 9N) of electrically conductive material are formed as further detailed in connection with Figures 9A to 9N.

These respective patterns of electrically conductive material have:
the planar coil geometry of the coil or coils 181, 182, thus providing such coil or coils (transformer windings), or
the geometrical distribution of the electrically conductive connections 120 to the semiconductor chip or chips 14, thus providing such.

As appreciable in Figures 3 to 8, the chips 14 are advantageously non-overlapping with the coils of the transformer 18.

The (at least substantial) absence of overlapping between the chips 14 and the coils of the transformer 18 was found to be advantageous as this minimizes undesired mutual influence between the two.

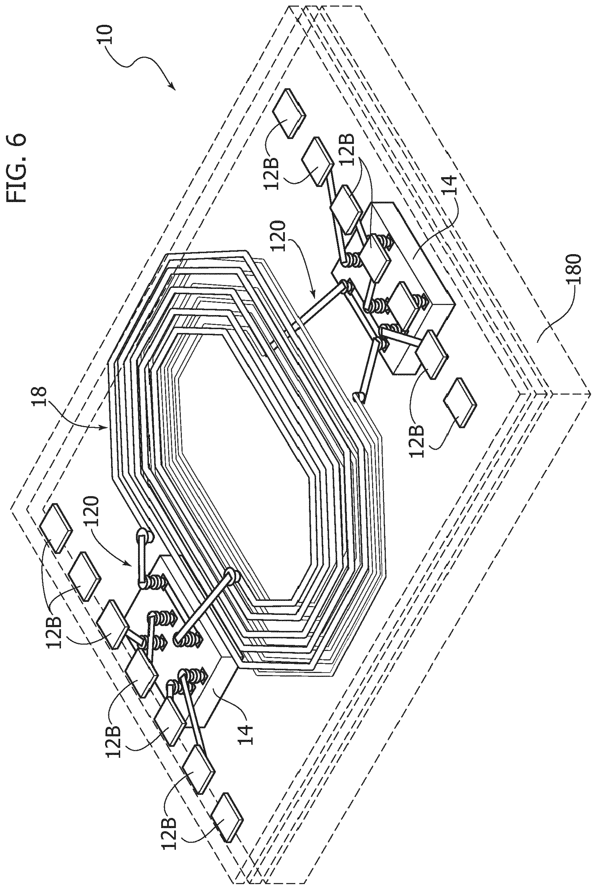

The comparison of Figures 3 to 5 (on the one side) and Figures 6 to 8 (on the other side) highlights the possibility of optimizing the layout (and thus the length) of the electrically conductive lines 120 that couple the dice 14 to the transformer 18.

Figures 3 to 5 are essentially exemplary of how the SiP of Figure 1 may "look like" if implemented using PEP technology. The design of the transformer 181, 182 is essentially unchanged; the dice 14 are identical and placed at the same distance from the transformer: performance is improved due to most of the wiring and the frame being dispensed with.

Figures 6 to 8 are exemplary of a (possible) optimization of the solution of Figures 3 to 5, showing how flexibility provided by PEP technology can further improve performance.

Shorter die-to-transformer connections as illustrated in Figures 6 to 8 facilitate reducing the overall size of the package 10.

For instance (and by way of non-limiting example) a system layout as exemplified in Figure 4 can be implemented on a 6 mm x 8 mm substrate of rectangular size while a system layout as exemplified in Figure 7 can be implemented on a substrate 180 of 5.5 x 7 mm of rectangular size.

Once more, those values are merely exemplary and not limiting of the embodiments.

Embodiments as exemplified in Figures 3 to 8 were found to provide significant advantages over conventional layouts as exemplified in Figures 1 and 2 in terms of inductance, resistance and coupling coefficient and Q- factor of the transformer arrangement.

Such improvements can be attributed primarily to two factors, namely:
metal leadframe portions under the transformer 18 such as the portions 1200 in Figure 1 can be dispensed with, and/or
the conventional wiring 120 is replaced with electrically conductive lines (traces) formed at the layers L0 and L1 to L4.

Modulating the thickness of the electrically conductive traces facilitates reducing the associated electrical resistance and to increase the Q-factor. Such an approach is hardly feasible in the presence a leadframe having a fixed thickness.

Advantageously, the respective patterns of electrically conductive material are grown, e.g., via plating, on the electrically insulating material of the layers L0, L1, L2, L3, L4.

A sequence which may be applied in manufacturing packages 10 as exemplified in Figures 3 to 8, will now be described in connection with Figures 9A to 9N.

It will be otherwise appreciated that the sequence of steps of Figures 9A to 9N is merely exemplary insofar as:
one or more steps illustrated in Figures 9A to 9N can be omitted, performed in a different manner (with other tools, for instance) and/or replaced by other steps;
additional steps may be added;

one or more steps can be carried out in a sequence different from the sequence illustrated.

Figure 9A is exemplary of the lamination (at a "wafer" level) of a first layer L0 onto a semiconductor chip or die 14.

It is noted that solutions described herein apply to arrangements where a plural chips or dice 14 are present and to arrangements comprising a single chip or die 14.

Likewise, while arrangements including plural coils (e.g., the primary and secondary windings 181, 182 of a transformer 18) are shown in the figures, the solutions described herein apply also to arrangements where a single coil is present.

Figure 9B is exemplary of through vias 1000 being formed (in a manner known per se to those of skill in the art, e.g., via laser beam processing) through the layer L0.

Figure 9C is exemplary of wafer grinding and dicing (e.g., via a cutting blade) as indicated at B.

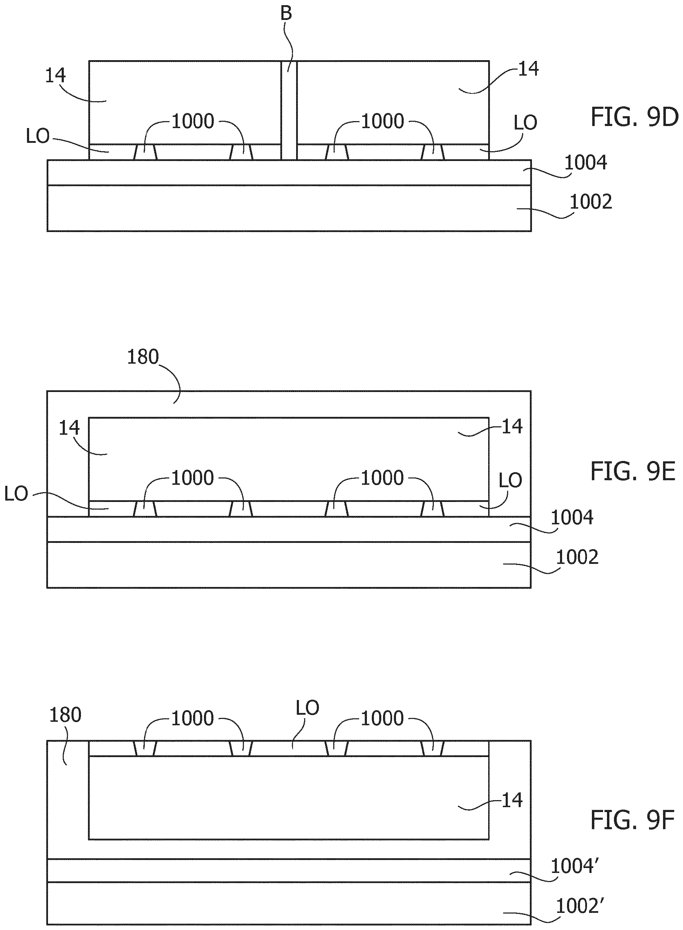

Figure 9D is exemplary of (re)construction of a panel using a carrier 1002 onto which the structure obtained in Figure 9C is mounted "upside down" via an intermediate layer (a tape 1004, for instance).

Figure 9E is exemplary of encapsulation material (intended to form the support 180) being molded with subsequent mold grinding. Starting from Figure 9E a single chip or die 14 is shown for simplicity.

Figures 9A to 9E are thus exemplary of a semiconductor chip 14 being embedded at a first portion of an insulating encapsulation 180 via steps including:
singulating a semiconductor wafer comprising a plurality of semiconductor chips 14 into a plurality of individual semiconductor chips comprising that semiconductor chip 14,
arranging the plurality of individual semiconductor chips 14 thus obtained on a temporary carrier 1002,1004, and
molding an encapsulation material onto such a plurality of (individual) semiconductor chips, thus embedding that plurality of individual semiconductor chips in an insulating encapsulation 180.

Figures 9A to 9E are exemplary of an advantageous arrangement wherein a base layer is formed on a surface of the semiconductor chip 14, such base layer including electrically insulating material L0 as well as a respective pattern 1000 of electrically conductive material having a desired geometrical distribution.

The step of Figure 9E is followed in Figure 9F by panel release and transfer of the arrangement as obtained in Figure 9E (again turned upside down) onto a further carrier 1002' via an associated layer (such as tape 1004').

It is noted that, while indicated with a different reference for clarity, the carrier 1002' and layer 1004' may be the same type of carrier 1002 and layer 1004.

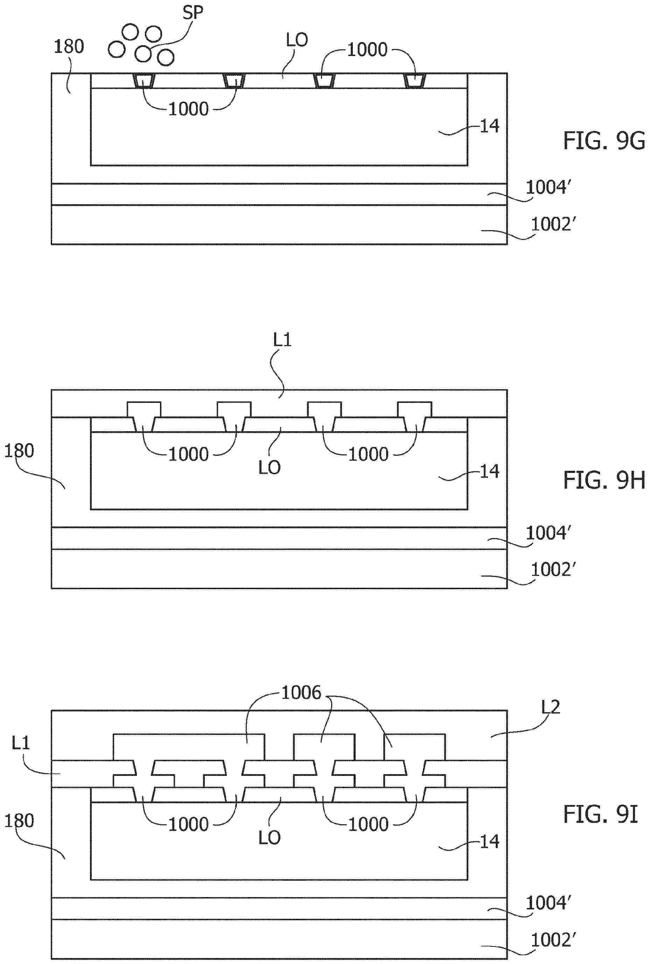

Figures 9G and 9H are exemplary of a sub-sequence of steps leading to the vias 1000 being made (fully) electrically conductive.

These steps may include:
a "seed" layer being formed, e.g., with Ti/Cu being applied via sputtering SP into the drilled vias 1000,
dry film lamination,
Laser Direct Imaging (LDI) and develop,
Cu galvanic growth, and
Cu/Ti etching, to complete the formation of electrically conductive contacts at the vias 1000.

These steps can be carried out in a manner known per se to those of skill in the art, also as regards possible alternatives for forming the seed layer.

The foregoing is followed by lamination of a layer L1 as discussed in the foregoing.

That is, processing of the base layer L0 in the stacked structure comprises forming (e.g., via deposition - by sputtering SP, for instance, of electrically conductive material such as copper or titanium) in the electrically insulating material of the base layer L0 in the stacked structure a respective pattern of locations promoting growth of electrically conductive material.

Electrically conductive material 1000 is then grown at those locations promoting growth of electrically conductive material.

Figure 9I is exemplary of steps as likewise discussed in the foregoing (namely dry film lamination, LDI and develop, Cu galvanic growth, Cu/Ti etch) resulting in the formation of electrically-conductive lines and contacts (collectively indicated by 1006 for simplicity) providing, e.g., one of the coils 181, 182 of the transformer 18 and the associated wiring 120 followed by lamination of a further layer L2.

It is noted that forming a seed layer (e.g., a Ti/Cu layer as applied via sputtering SP into the drilled vias 1000) is no longer needed in the subsequent steps of Figures 9I onwards insofar as in these subsequent steps plating of, e.g., Cu can take place on a homologous underlying layer (e.g., electrolytically plated copper).

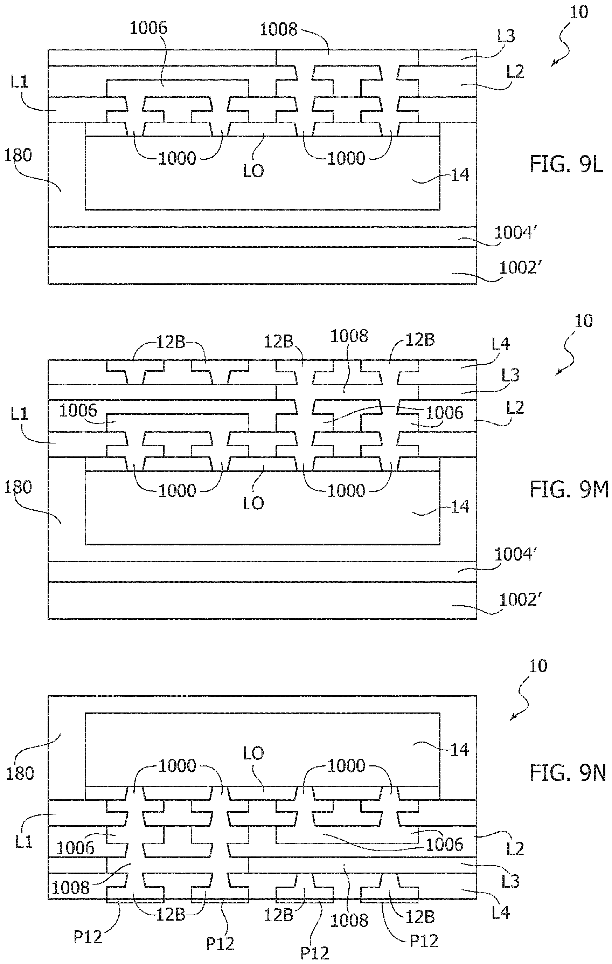

Figure 9L is exemplary of steps as discussed in the foregoing (namely dry film lamination, LDI and develop, Cu galvanic growth, Cu/Ti etch) being once more repeated leading to the formation of electrically-conductive lines and contacts (collectively indicated by 1008 for simplicity) providing, e.g., the other of the coils 181, 182 of the transformer 18 and the associated wiring 120 followed by lamination of a still further layer L3.

The same sequence of steps can be repeated as illustrated in Figure 9M to provide additional contacts, thus providing, in the case of a final layer L4, contacts suited to act as leads 12B for the package 10.

Finally, Figure 9N is exemplary of the release of the panel thus formed from the carrier 1002' and subsequent finishing steps such as electroless nickel immersion gold (ENIG) finishing of the leads 12B, as indicated at P12 and singulation.

Devices as considered herein may comprise one or more electrically conductive coils, such as, for instance a first electrically conductive coil 181 having a first planar coil geometry as well as a second electrically conductive coil 182 having a second planar coil geometry that facilitates inductive coupling to the first electrically conductive coil 181 to provide a transformer circuit.

The stacked structure of layers may thus comprise a first layer (e.g., L2) of electrically insulating material having a first pattern (e.g., 1006) of electrically conductive material. That first pattern has the first planar coil geometry and provides the first electrically conductive coil e.g., 181: this can be either the primary or the secondary winding of the transformer.

The stacked structure of layers may then comprise a second layer (e.g., L3) of electrically insulating material having a second pattern (e.g., 1008) of electrically conductive material at said second layer (L3). That second pattern has the second planar coil geometry and provides the second electrically conductive coil e.g., 182: this can be either the secondary or the primary winding of the transformer.

Devices as illustrated herein (in Figures 3 onwards) comprise, in addition to two electrically conductive coils 181, 182, a first and a second semiconductor chip 14 arranged at the first portion of the substrate 180.

In that case the stacked structure of layers comprises:
a third layer (e.g., L0) of electrically insulating material having a third pattern (e.g., 1000) of electrically conductive material providing a geometrical distribution of electrically conductive connections of the first semiconductor chip to the first electrically conductive coil 181 of the transformer circuit, and
a fourth layer (e.g., L4) of electrically insulating material having a fourth pattern (e.g., 12B) of electrically conductive material providing a geometrical distribution of electrically conductive connections 120 of the second semiconductor chip 14 to the second electrically conductive coil 182 of the transformer circuit 181, 182.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
embedding at least one semiconductor chip (14) in an insulating encapsulation (180) at a first portion thereof, and
forming over a second portion of the insulating encapsulation (180) at least partly non-overlapping with the first portion of the insulating encapsulation (180), at least one electrically conductive coil (181, 182) having a planar coil geometry and a geometrical distribution of electrically conductive connections (120) to the at least one semiconductor chip (14),
wherein the method comprises forming over the insulating encapsulation (180) having the semiconductor chip (14) embedded in the first portion thereof, a stacked structure of layers, wherein the layers in the stacked structure include electrically insulating material (L1, L2, L3, L4) as well as respective patterns (1006, 1008, 12B) of electrically conductive material, wherein said respective patterns of electrically conductive material have:
said planar coil geometry, thus providing said at least one electrically conductive coil (181, 182), or
said geometrical distribution, thus providing said electrically conductive connections (120).

2. The method of claim 1, wherein embedding at least one semiconductor chip (14) in an insulating encapsulation (180) at a first portion thereof comprises:
singulating a semiconductor wafer comprising a plurality of semiconductor chips (14) into a plurality of individual semiconductor chips (14) comprising the at least one semiconductor chip (14),
arranging the plurality of individual semiconductor chips (14) comprising the at least one semiconductor chip (14) on a temporary carrier (1002,1004),
molding an encapsulation material onto the plurality of individual semiconductor chips (14) comprising the at least one semiconductor chip (14) thus embedding a plurality of individual semiconductor chips (14) comprising the at least one semiconductor chip (14) in an insulating encapsulation (180).

3. The method of claim 1 or claim 2, comprising forming a base layer on a surface of the semiconductor chip (14), said base layer including electrically insulating material (L0) as well as at least one pattern (1000) of electrically conductive material having said geometrical distribution.

4. The method of any of claims 1 to 3, comprising growing said respective patterns (1000, 1006, 1008, 12B) of electrically conductive material on said electrically insulating material (L0, L1, L2, L3, L4).

5. The method of claim 4, comprising growing said respective patterns (1000, 1006, 1008, 12B) of electrically conductive material on said electrically insulating material (L0, L1, L2, L3, L4) via plating.

6. The method of claim 4 or claim 5, comprising:
forming (SP) in the electrically insulating material of the base layer (L0) a respective pattern of locations promoting growth of electrically conductive material, and
growing electrically conductive material (1000) at said locations promoting growth of electrically conductive material.

7. The method of claim 6, comprising forming (SP) said respective pattern of locations promoting growth of electrically conductive material via sputtering electrically conductive material at said locations.

8. The method of claim 6 or claim 7, comprising forming (SP) said respective pattern of locations promoting growth of electrically conductive material via deposition of copper or titanium.

9. The method of ony of the previous claims, wherein the layers in the stacked structure of layers (L1, L2, L3, L4) and/or the base layer (L0) formed on a surface of the semiconductor chip (14) are Ajinomoto Build-Up Films.

10. A device (10), comprising:
at least one semiconductor chip (14) embedded in an insulating encapsulation (180) at a first portion thereof, and
formed over a second portion of the insulating encapsulation (180) at least partly non-overlapping with the first portion of the insulating encapsulation (180), at least one electrically conductive coil (181, 182) having a planar coil geometry and a geometrical distribution of electrically conductive connections (120) to the at least one semiconductor chip (14),
wherein the device (10) comprises, formed over the insulating encapsulation (180) having the semiconductor chip (14) embedded in the first portion thereof, a stacked structure of layers, wherein the layers in the stacked structure include electrically insulating material (L1, L2, L3, L4) as well as respective patterns (1006, 1008, 12B) of electrically conductive material, wherein said respective patterns of electrically conductive material have:
said planar coil geometry, thus providing said at least one electrically conductive coil (181, 182) or
said geometrical distribution, thus providing said electrically conductive connections (120).

11. The device (10) of claim 10, comprising, formed on a surface of the semiconductor chip (14), a base layer including electrically insulating material (L0) as well as at least one respective pattern (1000) of electrically conductive material having said geometrical distribution.

12. The device (10) of claim 10 or claim 11, comprising, formed over said second portion of the insulating encapsulation (180):
a first electrically conductive coil (181), the first electrically conductive coil (181) having a first planar coil geometry,
a second electrically conductive coil (182), the second electrically conductive coil (182) having a second planar coil geometry and being inductively coupled to the first electrically conductive coil (181) to provide a transformer circuit (181, 182), and
wherein the stacked structure of layers comprises:
a first layer (L2) of electrically insulating material having a first pattern (1006) of electrically conductive material at said first layer (L2), said first pattern (1006) having said first planar coil geometry and providing the first electrically conductive coil (181) of said transformer circuit (181, 182), and
a second layer (L3) of electrically insulating material having a second pattern (1008) of electrically conductive material at said second layer (L3), said second pattern (1008) having said second planar coil geometry and providing the second electrically conductive coil (182) of said transformer circuit (181, 182) .

13. The device (10) of claim 12, comprising, embedded in the insulating encapsulation (180) at a first portion thereof, a first and a second semiconductor chip (14), and wherein the stacked structure of layers comprises a fourth layer (L4) of electrically insulating material having a fourth pattern (12B) of electrically conductive material providing a geometrical distribution of electrically conductive connections (120) of said first semiconductor chip (14) to said second electrically conductive coil (182) of said transformer circuit (181, 182).

14. The device (10) of any of the claims 10 to 13, wherein the layers in the stacked structure of layers (L1, L2, L3, L4) and/or the base layer (L0) formed on a surface of the semiconductor chip (14) are Ajinomoto Build-Up Films.
